# EUROPEAN PATENT APPLICATION

(11) **EP 3 432 424 A1**
(43) Date of publication of application: **23.01.2019**
(21) Application number: 17182262.0
(22) Date of filing: 20.07.2017
(51) Int. Cl.: H01R 24/44, H01R 24/50, H01R 13/6473, H01R 9/05, H01R 103/00, H01R 12/70

(54) **RF CONNECTOR WITH A SURFACE-MOUNT INTERFACE**

(71) Applicant: Spinner GmbH, 80335 München (DE)
(72) Inventor: The designation of the inventor has not yet been filed
(74) Representative: Lohr, Jöstingmeier & Partner

(57) **Abstract**

A RF connector system comprises an RF connector with PCB interface further comprising a housing, a coaxial RF connector interface and a PCB contact section together with a Printed Circuit Board (PCB). A mechanical connection is made by two wing shaped surface mount sections of the housing having a plurality of surface mount studs adapted to match which pads on the PCB. The electrical connection to the PCB is made by an inner conductor and at least one matching block electrically connected to the housing and providing a matched impedance at the PCB, which has a strip line with a ground plane.

## Description

### Field of the invention

The invention relates to an RF connector assembly which may be used for millimeter waves and which has a surface-mount interface for a printed circuit board (PCB).

### Description of the related art

A RF connector assembly is disclosed in US 6,607,400 B1. A connector is mounted into a cutout of a printed circuit board. The electrical contact is established by soldering pads to a ground plane and to a signal line. Due to their design, such connectors are only suitable for frequencies up to order of magnitude of 1 GHz. The connector is a miniature pushbutton connector. A larger connector with a higher weight cannot be mounted by the disclosed PCB interface.

A millimeter wave connector for interconnecting a microstrip circuit and an external circuit is disclosed in US 4,669,805. The connector is held in a housing, which also contains a microstrip substrate to be connected to the connector. During assembly, the flexible center conductor of the connector has to be bent to adapt to the microstrip circuit. Bending of the center conductor may cause asymmetries, which degrade the electrical characteristics of the connector.

### Summary of the invention

The problem to be solved by the invention is to provide a millimeter wave connector, which can be mounted to a printed circuit board (PCB) or any other microstrip substrate without requiring complex and expensive mounting tools. The connector should be designed such, that it can be mounted by automated tools. Solutions of the problem are described in the independent claims. The dependent claims relate to further improvements of the invention.

A millimeter wave or RF connector for printed circuit boards comprises housing, an RF connector interface, and a printed circuit board interface.

The RF connector interface may be any standard RF connector interface like SMA, 2.92mm, 1.85 mm or 1.0 mm. The RF connector interface preferably provides a coaxial connector interface having an outer conductor and an inner conductor. The coaxial RF connector interface may be mounted or attached to the housing. Preferably, the outer conductor is part of the housing, such that it is monolithic with the housing.

The housing comprises at least one, preferably two surface mount sections which may be part of the housing and preferably are monolithic with the housing. The surface mount sections may be formed as side wings to the housing, therefore requiring less space and material. Furthermore, side wings provide a lower thermal capacity. The at least one surface mount section has a plurality of surface mount studs which preferably are monolithic with the surface mount section. The surface mount studs may be soldered to the surface of a printed circuit board. They may be soldered to a continuous metal surface, like a ground plane. It is preferred if the surface mount studs are soldered to matching contact pads. These contact pads may be insulated from each other and/or from the system ground, as the ground connection may be done by the matching blocks which are part of the PCB contact section and are arranged close to the inner conductor exit of the housing. The contact pads may also be used for further grounding the connector. Most preferably, when using contact pads matching to the surface mount studs, centering of each surface mount stud to the corresponding contact pad is automatically done by surface tension of the soldering metal. Such a soldering metal may be any metal or combination of metals as known from prior art, e.g. tin, led, silver and others. The centering of the individual surface mount studs results in a total alignment of RF connector. Furthermore, the RF connector can easily be handled by automatic pick and place systems and needs no additional handling steps.

The housing preferably comprises a conductive material, most preferably a metal.

As the RF connector outer conductor is connected to or part of the housing, the outer connector can be contacted by means of the surface mount studs to a printed circuit board.

The center conductor of the coaxial RF connector interface is guided through the housing, preferably within a coaxial bore to maintain the coaxial structure by minimizing reflections. The inner conductor exits the housing at the PCB contact section, preferably at a side opposing to the side of the coaxial RF connector interface. At the exit side of the housing close to the inner conductor is at least one matching block in electrical contact with the housing, which keeps the capacitance of the inner conductor in the area of the exit side and the contact to the strip line of the printed circuit board corresponding to the inductance, such that the characteristic impedance is always constant and the reflections are minimized. Preferably, there are two matching blocks symmetrically arranged. Most preferably, they are in a plane such that they can contact a ground plane of the printed circuit board. Preferably, the matching blocks also act as soldering pads to provide an electrical connection to a ground plane of the printed circuit board.

For seating the housing, a cutout may be provided in the printed circuit board. Preferably, the cutout is at least slightly larger than the housing, such that there is a gap between the cutout and the housing. It is not necessary that the cutout exactly matches to the housing and holds the housing, as the housing itself is precisely centered by the surface mount studs which are further centered to the contact pads. Such a precision alignment is necessary to provide a perfect alignment at the exit side of the inner conductor with the strip line, which further results in minimal reflections at high frequencies.

In a preferred embodiment, an RF connector system is provided comprising of at least one RF connector as mentioned above and a matching printed circuit board as also mentioned above. To provide self-alignment of the RF connector to the printed circuit board, the contact pads of the printed circuit board preferably match to the surface mount studs of the RF connector. Preferably, the contact pads and the surface mount studs have a rectangular, and most preferably a squared cross-section. It is further preferred if the size of the contact pads is between 0.05 to 0.15 mm larger than the size of the surface mount studs. The surface mount studs may also have a circular or elliptical shape, whereas the size of the contact pads which may have a rectangular or circular or elliptical shape, is preferably in a range from 0.05 to 0.15 mm larger than the studs.

Preferably, the housing and most preferably the surface mount stud as well as the matching blocks have a surface which can be soldered easily. Preferably the surfaces are electro-plated.

### Description of Drawings

In the following the invention will be described by way of example, without limitation of the general inventive concept, on examples of embodiment with reference to the drawings.
- Figure 1: shows a perspective view of the RF connector with PCB interface.
- Figure 2: shows a detailed view of a surface mount section.
- Figure 3: shows a detail of the inner conductor connection.
- Figure 4: shows details of a surface mount stud.
- Figure 5: shows a top view of a RF connector wit PCB interface.
- Figure 6: shows a sectional view of the RF connector with PCB interface.

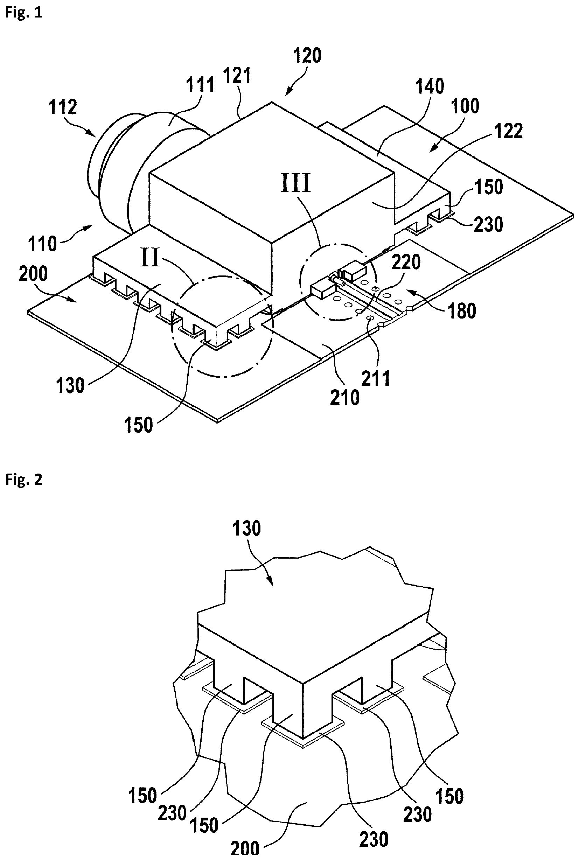

In Figure 1, a perspective view of the RF connector with PCB interface 100 is shown. It comprises a housing 120 comprising, preferably holding or being one part with a coaxial RF connector interface 110.

The coaxial RF connector interface 110 has an outer conductor 111 and a center conductor 112 coaxial to the outer conductor 111. The center conductor 112 cannot be seen here, but will be shown later in detail. The coaxial RF connector interface may be of any type. It may be male, female or hermaphroditic.

The housing 120, which preferably comprises a metal and preferably has a cuboid shape furthermore has at least one surface mount section 130, 140, which preferably are symmetrically arranged at two opposing sides of the housing. It is further preferred, if the surface mount sections have the shape of side wings. The surface mount sections may have a smaller thickness than the housing, therefore requiring less material and providing a lower thermal capacity, which may be beneficial for soldering. The at least one surface mount section comprises a plurality of surface mount studs 150. The surface mount studs are arranged in a common plane, such that a printed circuit board may be attached thereto. The surface mount studs preferably have a rectangular or squared cross-section, but they may have any other shape like a circular or elliptical cross-section.

The housing 120 preferably has a first side 121 with the coaxial RF connector interface and an exit side 122 bearing the PCB contact section 180 preferably opposing thereto. The exit side is used for contacting an inner conductor connected to or being part of the center conductor 112 to a printed circuit board, which is explained in more detail below.

Furthermore, this Figure shows a printed circuit board 200 having a plurality of contact pads 230 aligned with the surface mount studs. Furthermore, the printed circuit board has a strip line 220 and at least one (here: two) ground plane sections 210 insulated from the strip line. These ground plane sections are electrically connected together by a plurality of through-holes 211 passing to a lower electrical layer in the printed circuit board, which cannot be shown here. This layer connects the ground plane sections under (or over) the strip line.

In Figure 2, a detailed view of a surface mount section 130 (section II of Fig. 1) is shown having a plurality of surface mount studs 150 which are soldered to matching contact pads 230 of the printed circuit board 200.

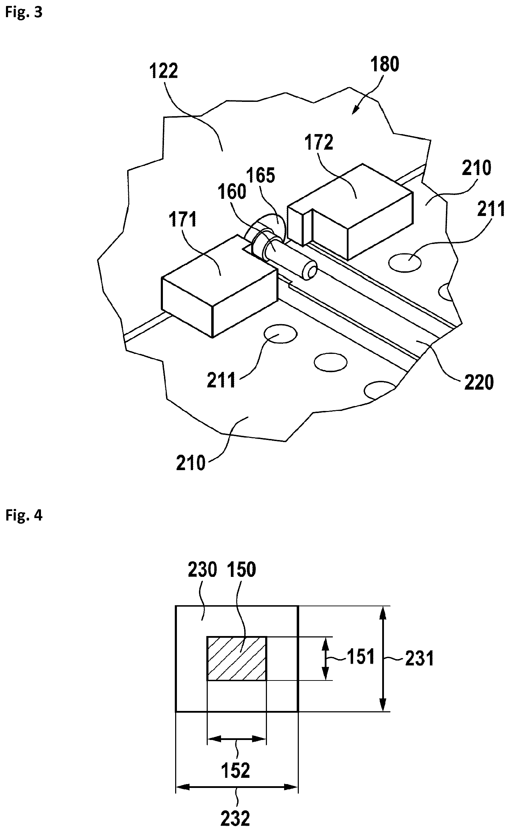

In Figure 3, a detail of the connection of inner conductor 160 (section III of Fig. 1) is shown. The inner conductor 160 exits the exit side 122 of the housing through bore 165 and may be soldered to a strip line 220. To keep the end section of the inner conductor 160 with minimized reflections, preferably one and most preferably two matching blocks 171, 172 are provided. These matching blocks also preferably are used to contact the housing 120 to a ground plane 210 of the printed circuit board by being soldered thereto.

In Figure 4, details of a surface mount stud 150 are shown, soldered on a matching contact pad 230. Here, the stud and the pad have a rectangular cross-section, preferably a squared cross-section. The surface mount stud 150 has a first side length 151 and a second side length 152. The contact pad 230 has a first side length 231 and a second side length 232. It is preferred, if the first side length 151 of the surface mount stud is between 0.05 and 0.15 mm smaller than the first side length 231 of contact pad 230. It is preferred, if the second side length 152 of the surface mount stud is between 0.05 and 0.15 mm smaller than the second side length 232 of contact pad 230.

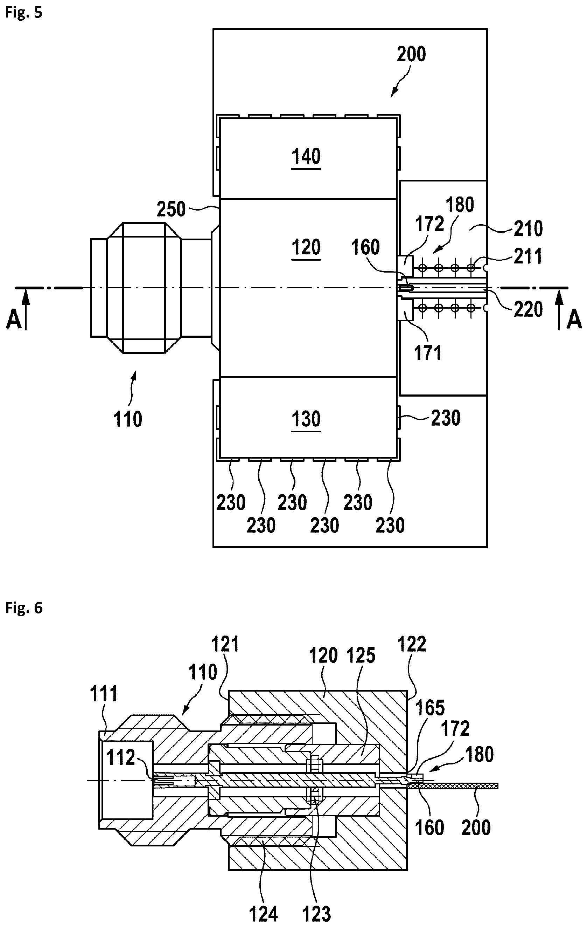

In Figure 5, a top view of the RF connector with PCB interface 100 mounted to a printed circuit board is shown. It shows the contact pads 230 as well as the ground plane 210 together with strip line 220. For seating the housing, a cutout 250 may be provided in the printed circuit board.

Preferably, the cutout is at least slightly larger than the housing, such that there is a gap between the cutout and the housing. It is not necessary that the cutout exactly matches to the housing and holds the housing, as the housing itself is precisely centered by the surface mount studs which are further centered to the contact pads. Such a precision alignment is necessary to provide a perfect alignment at the exit side of the inner conductor with the strip line, which further results in minimal reflections at high frequencies.

In Figure 6, a sectional view of the RF connector with PCB interface is shown. In this view, the path of the center conductor connection is shown. The center conductor 112 of the coaxial RF connector interface is guided as an inner conductor 160 through a bore 165 at exit side 122. The inner conductor 160 may be one piece with the center conductor 112. It may also be a wire or other metal structure electrically and preferably mechanically connected to the center conductor 112. The center conductor 112 and/or inner conductor 160 may be mechanically supported by spacers 123 which are held by outer conductor sections 125. In this figure, the Coaxial RF connector interface 110 is held by a thread 124 in the housing 120. Therefore, it may be replaced or it may be part of a modular system comprising multiple different connector interfaces fitting into the same housing.

### List of reference numerals

- 100: RF connector wit PCB interface
- 110: Coaxial RF connector interface
- 111: outer conductor
- 112: center conductor
- 120: housing
- 121: Coaxial RF connector interface (first) side of housing
- 122: exit side of housing
- 123: spacer
- 124: thread
- 125: outer conductor section
- 130, 140: surface mount section
- 150: surface mount stud
- 151: first side length
- 152: second side length
- 160: inner conductor
- 165: bore
- 171, 172: matching blocks
- 180: PCB contact section
- 200: printed circuit board (PCB)
- 210: ground plane
- 211: through holes
- 220: strip line
- 230: contact pads
- 231: first side length
- 232: second side length
- 250: cutout

## Claims

1. RF connector with PCB interface (100) comprising a housing (120), a coaxial RF connector interface (110) and a PCB contact section (180);
the coaxial RF connector interface (110) comprising an outer conductor (111) and a center conductor (112);
the housing (120) comprising at least one surface mount section (130, 140), the at least one surface mount section (130, 140) further comprising a plurality of surface mount studs (150); and
the PCB contact section (180) comprising an inner conductor (160) passing through a bore (165) of the housing and at least one matching block (171, 172) electrically connected to the housing (120) and providing a matched impedance at the PCB contact section, the inner conductor (160) being electrically connected with the center conductor (112).

2. RF connector (100) according to claim 1,
**characterized in, that**
the housing (120) comprises a metal having a cuboid shape.

3. RF connector (100) according to any one of the previous claims,
**characterized in, that**
the housing (120) comprises two surface mount sections (130, 140) which are symmetrically arranged at two opposing sides of the housing.

4. RF connector (100) according to any one of the previous claims,
**characterized in, that**
the surface mount sections (130, 140) have a smaller thickness than the housing (120).

5. RF connector (100) according to any one of the previous claims,
**characterized in, that**
the surface mount studs (150) are arranged in a common plane.

6. RF connector (100) according to any one of the previous claims,
**characterized in, that**
the surface mount studs (150) have a rectangular or squared cross-section.

7. RF connector (100) according to any one of the previous claims,
**characterized in, that**
the PCB contact section (180) is at an exit side (122) of the housing (120) opposing to a first side (121) with the coaxial RF connector interface (110).

8. RF connector system comprising an RF connector according to any one of the previous claims and a Printed Circuit Board (PCB) (200),
**characterized in, that**
the PCB comprises at least one contact pad (230) matching to the at least one surface mount stud (150), at least one strip line (220) matching to the at least one inner conductor (160) and at least one ground plane (210) matching to the at least one matching blocks (171, 172).

9. RF connector system according to claim 8,
**characterized in, that**
the at least one strip line (220) is insulated from and in a PCB layer above or under the at least one ground plane (210).

10. RF connector system according to claim 8 or 9,
**characterized in, that**
the at least one at least one contact pad (230) is electrically insulated from the at least one ground plane (210).
